# EUROPÄISCHE PATENTSCHRIFT

(11) **EP 0 270 622 B1**
(45) Veröffentlichungstag und Bekanntmachung des Hinweises auf die Patenterteilung: **03.02.1993**
(21) Anmeldenummer: 87903855.2
(22) Anmeldetag: 12.06.1987
(51) Int. Cl.: H02H 3/087, H03K 17/08

(54) **ELEKTRONISCHE STEUERSCHALTUNG, INSBESONDERE FÜR EINEN DRUCKER**
ELECTRONIC CONTROL SYSTEM, IN PARTICULAR FOR A PRINTER
CIRCUIT DE COMMANDE ELECTRONIQUE, NOTAMMENT POUR IMPRIMANTE

(30) Priorität: 19.06.1986 DE 3620535
(43) Veröffentlichungstag der Anmeldung: 15.06.1988
(73) Patentinhaber: MANNESMANN Aktiengesellschaft, 40027 Düsseldorf (DE)
(72) Erfinder: KRAUSE, Jürgen, D-7732 Niedereschach (DE)
(74) Vertreter: Meissner, Peter E., Dipl.-Ing.
(86) Internationale Anmeldenummer: DE8700274
(87) Internationale Veröffentlichungsnummer: WO8707987

(56) Entgegenhaltungen:
- DE-A- 3 238 899
- DE-A- 3 322 932
- FR-A- 2 220 112
- IBM Technical Disclosure Bulletin, Band 23, Nr. 11, April 1981, (NewYork U.S), P.Kovach: " Current sensor",Seiten 4898-4899.
- Patent Abstracts of Japan, Band 6, Nr. 51, (P-108)(929), 6. April 1982, siehe ganze Zusammenfassung & JP-A-56164416.

## Beschreibung

Die Erfindung betrifft eine elektronische Steuerschaltung, insbesondere für einen Drucker, die eine Sicherungsschaltung für durch überströme oder überspannung gefährdete Bauelemente umfaßt, wobei Leistungselemente den Effektoren vorgeschaltet sind und wobei Leistungselemente und Effektoren für einen Impulsbetrieb ausgelegt sind und die Verbraucher bei über- oder Unterschreiten des vorgeschriebenen Stroms bzw. der vorgeschriebenen Spannung ab- bzw. zuschaltbar sind.

In der Geräteelektronik, insbesondere in der Druckerelektronik sind neben den Logikelementen eine Reihe von Leistungselementen in Gebrauch, die in der Regel mit einer Spannung zwischen 30 V und 50 V betrieben werden. Derartige Leistungselemente treiben als Leistungsschalter die sog. Effektoren (Verbraucher), wie z.B. Elektromagnetspulen in Druckerbaugruppen und Nadeldruckköpfen, Gleichstrommotoren und Schrittmotoren.

Sowohl die Leistungselemente als auch die Effektoren sind üblicherweise für den Impulsbetrieb ausgelegt und nicht für eine höhere relative Einschaltdauer. Keinesfalls wird jedoch eine 100 %ige relative Einschaltdauer vorausgesetzt.

In vielen Betriebsphasen sind irreguläre Betriebszustände innerhalb einer Gerätesteurung, insbesondere innerhalb einer Druckersteuerung nicht auszuschließen. Beim Zu- und Abschalten der Betriebsspannung und in der Testphase (z.B. beim Stoppen des Programmes mit Emulator) sind die Effektoren gefährdet und können beschädigt oder garzerstört werden.

Gemäß dem Stand der Technik sind Sicherungsschaltungen bekannt, bei denen in der Spannungszuführung der Leistungselemente Schalter in Form von Leistungstransistoren angeordnet sind. Diese Leistungstransistoren sind relativ groß und teuer und müssen - von Ausnahmen abgesehen - gekühlt werden, da sie eine hohe Verlustleistung erbringen. Außerdem wird bei derartigen Leistungstransistoren die Effektorspannung um den Betrag der Kollektor-Emitter-Spannung reduziert, so daß die Leistung des Verbrauchers um den Betrag der Verlustleistung des Leistungstransistors absinkt.

Es ist bekannt (IBM Technical Disclosure Bulletin, Vol. 23 No. 11, April 1981, Seite 4898), zwecks Antriebs eines Druckhammers in einer Elektromagnetspule durch eine Steuerschaltung in einem Zerhacker-System den Strom zu begrenzen.

Der vorliegenden Erfindung liegt die Aufgabe zugrunde, unter Vermeidung der geschilderten Nachteile eine Sicherungsschaltung innerhalb einer elektronischen Steuerschaltung, insbesondere für Drucker, vorzuschlagen, die gestattet, einen Effektor schon im Vorfeld gegen unerwünscht hohe Ströme bzw. Spannungen abzuschirmen, so daß ein Durchgriff dieser zerstörenden Spannungen bzw. Ströme praktisch ausgeschlossen ist.

Die gestellte Aufgabe wird bei der eingangs bezeichneten elektronischen Steuerschaltung erfindunsgemäß dadurch gelöst, daß ein Effektor im Betriebsfall ansteuerbar und gleichzeitig eine Referenzspannung in Abhängigkeit davon, ob die Betriebsspannung innerhalb eines Zulässigen Toleranzbereichs liegt, Zugeschaltet wird, bei deren überschreiten der Effektor abschaltbar ist. Grundsätzlich wird der Effektor demzufolge nur angesteuert, wenn dessen Funktion für den Betrieb eines Gerätes, wie z.B. eines Druckers, benötigt wird. In einem solchen Fall wird der Effektor jedoch nur dann bestromt, wenn die Betriebsspannung innerhalb eines vorherbestimmten zulässigen Toleranzbereichs liegt. Die Bestromung ist daher zunächst an die Ansteuerung und an den Spannungstoleranzbereich geknüpft.

Nach einer Ausgestaltung der Erfindung wird vorgeschlagen, daß dem Effektor ein Verstärker und diesem ein Komparator für den Vergleich der Referenzspannung mit der durch den Effektorstrom erzeugten Spannung vorgeschaltet ist und daß die Referenzspannung in Abhängigkeit zweier hintereinandergeschalteter Transistoren erzeugbar ist, von denen der vorgeschaltete Transistor nur mit einer Betriebsspannung im zulässigen Toleranzbereich durchschaltbar ist und der nachgeschaltete Transistor nur bei durchgeschaltetem, vorgeschaltetem Transistor durchschaltbar ist, um die Referenzspannung zu erzeugen. Im Gegensatz zum Stand der Technik werden hier lediglich Transistoren der preiswertesten Bauart, d.h. nach der sog. SMD-Technik hergestellte Transistoren benötigt (SMD = Surface-Mounted-Devices).

Eine andere Ausgestaltung der Erfindung sieht vor, daß der vorgeschaltete Transistor nur dann durchschaltbar ist, wenn ein vorgeschalteter, wiedertriggerbarer monostabiler Multivibrator innerhalb einer eingestellten Zeit durch die angeschlossene Effektorsteuerung getriggert ist. Demzufolge ist die eingestellte Zeit der Ansteuerung des betreffenden Effektors eine weitere Voraussetzung für die Durchschaltung der Transistoren.

Eine weitere Sicherheitsstufe wird dadurch erzielt, daß der wiedertriggerbare monostabile Multivibrator über ein UND-Gatter an den vorgeschalteten Transistor angeschlossen ist und daß das UND-Gatter an eine separate Spannungsüberwachung angeschlossen ist. Demzufolge sind eine Spannungsgutmeldung und die Ansteuerung des betreffenden Bauteils weitere Voraussetzungen für die Ansteuerung des vorgeschalteten Transistors.

Eine weitere Ausgestaltung der Erfindung stellt dar, daß der Komparator und die die Referenzspannung erzeugenden Widerstände einen integrierten Bauteil bilden.

Der Anwendungsbereich der Erfindung kann nach zusätzlichen Merkmalen dahingehend gestaltet sein, daß jeweils einem Effektor oder einer Gruppe von Effektoren ein durch die Betriebsspannung im zulässigen Toleranzbereich schaltbarer Transistor und der diesem nachgeschaltete Transistor zugeordnet sind.

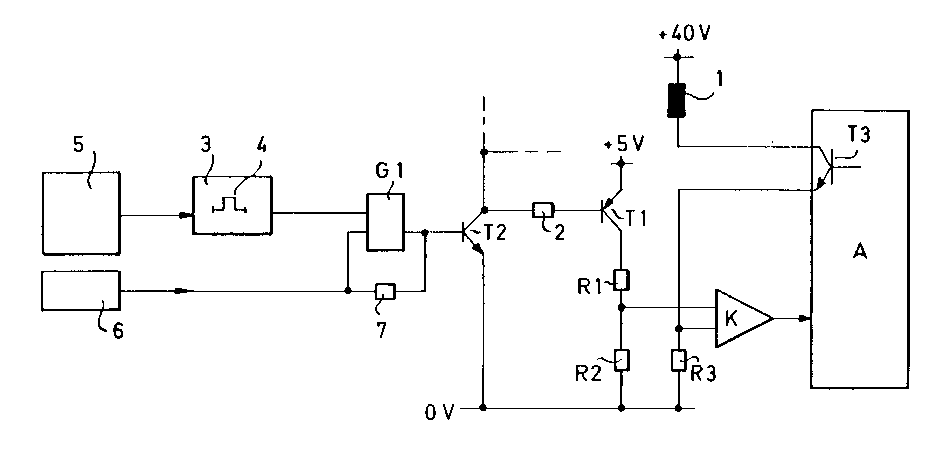

Ein Ausführungsbeispiel der Erfindung ist in der Zeichnung dargestellt und wird im folgenden näher beschrieben.

Die einzige Figur der Zeichnung zeigt die erfindungsgemäße Steuerschaltung in vereinfachter Darstellung.

Der Effektor (1) kann Bauteil einer beliebigen elektronischen Steuerschaltung sein und besteht innerhalb einer Druckersteuerung aus einer Induktivität mit sehr niedrigem Ohm'schen Widerstand. Der Effektor (1) kann deshalb auch aus der Wicklung eines Gleichstrommotors, eines Schrittmotors oder aus der Elektromagnetspule eines Nadeldruckkopfes für einen Matrixnadeldrucker bestehen. Ein Komparator (K) vergleicht die am Widerstand (R3) durch den Verbraucherstrom erzeugte Spannung mit der durch Referenzwiderstände (R1 und R2) eingestellten Referenzspannung. Bei überschreiten der Referenzspannung schaltet der Komparator (K) über einen Verstärker (A) den Effektor (1) - Verbraucher - ab. Der vorstehend beschriebene Schaltungsteil bedeutet eine erste Sicherheitsstufe, um den Effektor (1) vor Schäden oder vor der völligen Zerstörung zu bewahren. Im normalen Betriebsfall wird daher der Komparator (K) über den Verstärker (A), d.h. dessen Transistor (T3), den Effektor (1) einschalten.

Die Referenzspannung (R1/R2) wird jedoch nur dann erzeugt, wenn ein dem Widerstand (R1) vorgeschalteter Transistor (T1) - vom Typ PNP - durchgeschaltet ist. Für den Fall, daß der Transistor (T1) sperrt, ist die Referenzspannung (R1/R2) gleich Null, so daß der Effektor (1) durch den Komparator (K) ständig ausgeschaltet bleibt. Der Transistor (T1) wird nur geöffnet, wenn ein dem Transistor (T1) vorgeschalteter Transistor (T2) - vom Typ NPN -, dessen Kollektor über einen Schutzwiderstand (2) mit der Basis des Transistors (T1) verbunden ist, durchgeschaltet wird. Der vorstehend beschriebene Schaltungsteil bedeutet daher deine zweite Sicherheitsstufe, um den Effektor (1) vor Schaden zu bewahren.

Der Transistor (T2) wird nur dann geöffnet, wenn die Betriebsspannung im zulässigen Toleranzbereich liegt und ein wiedertriggerbarer, monostabiler Multivibrator (3), der ein entsprechendes Signal (4) von einer Effektorsteuerung (5) erhält, getriggert wird. Die Effektorsteuerung (5) besteht bei einem Drucker aus der Druckersteuerung. Für den Fall, daß der Multivibrator (3) nicht innerhalb der eingestellten Zeit wiedergetriggert wird, wird über ein UND-Gatter (G1), das zwischen den Multivibrator (3) und den Transistor (T2) geschaltet ist, der Transistor (T2) gesperrt. Da der Transistor (T2) gesperrt ist, wird auch der Transistor (T1) nicht angesteuert, so daß keine Referenzspannung (R1/R2) entstehen kann. Der vorstehend beschriebene Schaltungsteil bedeutet daher eine dritte Sicherheitsstufe, um den Effektor (1) vor Schaden zu bewahren.

Weiterhin ist eine Spannungsüberwachung (6) vorgesehen, die aus einem integrierten Baustein mit Transistorschaltung besteht und die die Eingangsspannung (hier z.B. S V) überprüft. Die Spannungsüberwachung gibt eine Spannungsgutmeldung oder eine Spannungsschlechtmeldung über das UND-Gatter (G1). Ein Widerstand (7) ist zwischen die Basis des Transistors (T2) und das Gatter (G1) geschaltet, da es sich bei dem Gatter (G1) um einen Bauteil mit offenem Kollektor handelt. Die Spannungsüberwachung (6) bedeutet nunmehr eine vierte Sicherheitsstufe, um den Effektor (1) vor Schaden zu bewahren. Hierbei wird davon ausgegangen, daß die vorliegende Sicherheitseinrichtung nicht nur für den Betrieb des entsprechenden Gerätes, d.h. für die Steuerung eines Druckers gedacht ist, sondern auch für dessen Testphasen, in denen besondere Schaltzustände eintreten können.

## Patentansprüche

1. Elektronische Steuerschaltung, insbesondere für einen Drucker, die eine Sicherungsschaltung für durch überströme oder überspannung gefährdete Bauelemente umfaßt, wobei Leistungselemente (T3) den Effektoren (1) vorgeschaltet sind und wobei Leistungselemente und Effektoren für einen Impulsbetrieb ausgelegt sind und die Verbraucher bei über- oder Unterschreiten des vorgeschriebenen Stromes bzw. der vorgeschriebenen Spannung ab- bzw. zuschaltbar sind,
dadurch gekennzeichnet,
daß ein Effektor (1) im Betriebsfall ansteuerbar und gleichzeitig eine Referenzspannung (R1/R2) in Abhängigkeit davon, ob die Betriebsspannung innerhalb eines zulässigen Toleranzbereichs liegt, zugeschaltet wird, bei dessen überschreiten der Effektor (1) abschaltbar ist.

2. Elektronische Steuerschaltung nach Anspruch 1,
dadurch gekennzeichnet,
daß dem Effektor (1) ein Verstärker (A) und diesem ein Komparator (K) für den Vergleich der Referenzspannung (R1/R2) mit der durch den Effektorstrom erzeugten Spannung vorgeschaltet ist und daß die Referenzspannung (R1/R2) in Abhängigkeit zweier hintereinandergeschalteter Transistoren (T1/T2) erzeugbar ist, von denen der vorgeschaltete Transistor (T2) nur mit einer Betriebsspannung im zulässigen Toleranzbereich durchschaltbar ist und der nachgeschaltete Transistor (T1) nur bei durchgeschaltetem, vorgeschaltetem Transistor (T2) durchschaltbar ist, um die Referenzspannung (R1/R2) zu erzeugen.

3. Elektronische Steuerschaltung nach den Ansprüchen 1 und 2,
dadurch gekennzeichnet,
daß der vorgeschaltete Transistor (T2) nur dann durchschaltbar ist, wenn ein vorgeschalteter wiedertriggerbarer monostabiler Multivibrator (3) innerhalb einer eingestellten Zeit durch die angeschlossene Effektorsteuerung getriggert ist.

4. Elektronische Steuerschaltung nach den Ansprüchen 1 bis 3,
dadurch gekennzeichnet,
daß der wiedertriggerbare monostabile Multivibrator (3) über ein UND-Gatter (G1) an den vorgeschalteten Transistor (T2) angeschlossen ist und daß das UND-Gatter (G1) an eine separate Spannungsüberwachung (6) angeschlossen ist.

5. Elektronische Steuerschaltung nach den Ansprüchen 1 bis 4,
dadurch gekennzeichnet,
daß der Komparator (K) und die die Referenzspannung erzeugenden Widerstände (R1,R2) einen integrierten Bauteil bilden.

6. Elektronische Steuerschaltung nach einem oder mehreren der Ansprüche 1 bis 5,
dadurch gekennzeichnet,
daß jeweils einem Effektor (1) oder einer Gruppe von Effektoren (1) ein durch die Betriebsspannung im zulässigen Toleranzbereich schaltbarer Transistor (T2) und der diesem nachgeschaltete Transistor (T1) zugeordnet sind.

## Claims

1. An electronic control circuit, in particular for a printer, which comprises a fuse circuit for elements which are at risk due to excess currents or excess voltage, whereby power elements (T3) precede the effectors (1) and whereby power elements and effectors are designed for pulsed operation and the consumers can be switched off or on when the current or voltage exceeds or drops below the prescribed current or the prescribed voltage,
characterised in that
an effector (1) in operation can be triggered and at the same time a reference voltage (R1/R2) is switched on dependent on whether the operating voltage lies within a permissible tolerance field, upon the exceeding of which the effector (1) can be switched off.

2. An electronic control circuit according to Claim 1, characterized in that the effector (1) is preceded by an amplifier (A), and said amplifier by a comparator (K) for comparing the reference voltage (R1/R2) with the voltage produced by the effector current, and that the reference voltage (R1/R2) can be generated dependent on two transistors (T1/T2) connected in series, of which the preceding transistor (T2) can only be connected through with an operating voltage within the permissible tolerance field and the succeeding transistor (T1) can only be connected through when the preceding transistor (T2) is connected through, in order to generate the reference voltage (R1/R2).

3. An electronic control circuit according to Claims 1 and 2, characterized in that the preceding transistor (T2) can only be connected through when a preceding, re-triggerable monostable multivibrator (3) is triggered by the connected effector control within a set period.

4. An electronic control circuit according to Claims 1 to 3, characterized in that the re-triggerable monostable multivibrator (3) is connected to the preceding transistor (T2) via an AND-gate (G1) and that the AND-gate (G1) is connected to a separate voltage monitoring means (6).

5. An electronic control circuit according to Claims 1 to 4, characterized in that the comparator (K) and the resistors (R1,R2) generating the reference voltage form an integrated component.

6. An electronic control circuit according to one or more of Claims 1 to 5, characterized in that a transistor (T2) which can be connected by the operating voltage in the permissible tolerance field and the transistor (T1) succeeding it are associated in each case with one effector (1) or a group of effectors (1).

## Revendications

1. Circuit de commande électronique, en particulier pour une imprimante, qui comporte un circuit de sécurité pour des éléments constructifs menacés par des surtensions ou des surintensités de courant, des éléments de puissance (T3) étant disposés en amont des effecteurs (1), et les éléments de puissance et les effecteurs étant étudiés pour un régime impulsionnel, et les utilisateurs pouvant être mis en circuit ou hors circuit lorsque ledit courant ou ladite tension est dépassé ou n'est pas atteint, caractérisé en ce qu'un effecteur (1) peut être excité et, en même temps, une tension de référence (R1/R2) est mise en circuit de façon dépendant de cela, si la tension de service se trouve à l'intérieur d'un domaine de tolérance acceptable, l'effecteur (1) étant mis hors circuit lors de son dépassement.

2. Circuit de commande électronique selon la revendication 1,
caractérisé en ce qu'un amplificateur (A) est disposé en amont de l'effecteur (1) et, en amont de l'amplificateur, est prévu un comparateur (K) pour comparer la tension de référence (R1/R2) avec la tension créée par le courant de l'effecteur, et en ce que la tension de référence (R1/R2) peut être créée sous la dépendance de deux transistors (T1/T2) montés l'un derrière l'autre, desquels le transistor en amont (T2) ne peut être passant qu'avec une tension de service dans le domaine de tolérance acceptable, et le transistor en aval (T1) ne peut être passant que lorsque le transistor amont (T2) est passant, pour créer la tension de référence (R1/R2).

3. Circuit de commande électronique selon les revendications 1 et 2,
caractérisé en ce que le transistor amont (T2) ne peut être passant que lorsqu'un multivibrateur monostable, disposé en amont, redéclenchable (3) est déclenché, à l'intérieur d'un temps défini, par la commande de l'effecteur qui y est raccordée.

4. Circuit de commande électronique selon les revendications 1 à 3,
caractérisé en ce que le multivibrateur monostable redéclenchable (3) est raccordé au transistor amont (T2) par l'intermédiaire d'une porte ET (G1), et en ce que la porte ET (G1) est raccordée à un moyen séparé de surveillance de tension (6).

5. Circuit de commande électronique selon les revendications 1 à 4,
caractérisé en ce que le comparateur (K) et les résistances (R1,R2) créant la tension de référence forment un composant intégré.

6. Circuit de commande électronique selon une ou plusieurs des revendications 1 à 5,
caractérisé en ce qu'un transistor (T2) qui peut être mis en circuit par la tension de service dans le domaine de tolérance acceptable et le transistor (T1) en aval de celui-ci sont associés, à chaque fois, à un effecteur (1) ou à un groupe d'effecteurs (1).
